# EUROPEAN PATENT SPECIFICATION

(11) **EP 3 772 666 B1**
(45) Date of publication and mention of the grant of the patent: **02.04.2025**
(21) Application number: 20189332.8
(22) Date of filing: 04.08.2020
(51) Int. Cl.: G02B 1/14, B32B 27/00, G02F 1/1333, G06F 1/16, H04M 1/02

(54) **COVER WINDOW AND FLEXIBLE DISPLAY DEVICE INCLUDING THE SAME**
ABDECKFENSTER UND FLEXIBLE ANZEIGEVORRICHTUNG DAMIT
FENÊTRE DE COUVERCLE ET DISPOSITIF D'AFFICHAGE FLEXIBLE LA COMPRENANT

(30) Priority: 08.08.2019 KR 20190096737
(43) Date of publication of application: 10.02.2021
(73) Proprietor: Samsung Display Co., Ltd., Yongin-si, Gyeonggi-Do 17113 (KR)
(72) Inventor: OH, Hye-Jin, 213-601 Seoul (KR); PARK, Young Sang, 104-3302 Seoul (KR); SEO, In Seok, Chungcheongnam-do (KR); AN, Sung Guk, 316-1705 Suwon-si, Gyeonggi-do (KR); AHN, Hung Kun, 509-204 Gyeonggi-do (KR); LEE, Jang Doo, Gyeonggi-do Gyeonggi-do (KR)
(74) Representative: Dr. Weitzel & Partner

(56) References cited:
- EP-A1- 3 173 856
- JP-A- S6 017 421
- KR-A- 20150 047 356
- US-A1- 2012 301 730
- US-A1- 2015 241 606

## Description

### BACKGROUND

### (a) Field

This disclosure relates to a cover window and a flexible display device including the same.

### (b) Description of the Related Art

Display devices such as an organic light emitting device and a liquid crystal display include display panels manufactured by providing a plurality of layers and elements on a substrate. Glass is used for the substrate of the display panel. However, the glass substrate is relatively heavy and easily broken. Further, the glass substrate is relative rigid so transforming the display panel into different shapes may be difficult.

### SUMMARY

Embodiments provide a cover window for preventing or reducing deformation of a bending area of a display device and improving durability thereof.

The cover window of the invention is defined by the features of claim 1. Preferred features are defined in the dependent claims.

### BRIEF DESCRIPTION OF THE DRAWINGS

The above and other advantages and features of this disclosure will become more apparent by describing in further detail exemplary embodiments thereof with reference to the accompanying drawings, in which:
FIG. 1 shows a schematic perspective view of an exemplary embodiment a display device which is unfolded.
FIG. 2 shows a schematic perspective view of an exemplary embodiment of a display device shown in FIG. 1, which is folded.
FIG. 3 shows a schematic perspective view of an exemplary embodiment of a display device shown in FIG. 1, which is folded.
FIG. 4 shows a cross-sectional view of an exemplary embodiment of a display device with respect to line IV-IV' in FIG. 1.
FIG. 5 shows a cross-sectional view of an exemplary embodiment of a display device with respect to line IV-IV' in FIG. 1.
FIG. 6 shows a cross-sectional view of an exemplary embodiment of a cover window.
FIG. 7 shows a cross-sectional view of an example not falling under the scope of protection of a cover window.
FIG. 8 shows a cross-sectional view of an example not falling under the scope of protection of a cover window.
FIG. 9 shows a cross-sectional view of an exemplary embodiment of a cover window.
FIG. 10 shows a cross-sectional view of an exemplary embodiment of a protection layer.
FIG. 11 shows a cross-sectional view of an example not falling under the scope of protection of a display panel.

### DETAILED DESCRIPTION

In the following detailed description, only certain exemplary embodiments have been shown and described, simply by way of illustration.

The size and thickness of each component shown in the drawings are arbitrarily shown for better understanding and ease of description. For better understanding and ease of description, the thicknesses of some layers and areas are exaggerated in the drawings.

It will be understood that when an element such as a layer, film, region, or substrate is referred to as being related to another element such as being "on" another element, it can be directly on the other element or intervening elements may also be present. In contrast, when an element is referred to as being related to another elements such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Like reference numerals designate like elements throughout the specification.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. In the present specification, unless explicitly described to the contrary, the words "comprise" and "include" and variations such as "comprises" or "comprising" will be understood to imply the inclusion of stated elements, but not the exclusion of any other elements.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

The phrase "in a plan view" or "in a top plan view" means viewing the object portion from the top, and the phrase "in a cross-section" means viewing a cross-section of which the object portion is vertically cut from the side.

In the drawings, a symbol x denotes a first direction, a symbol y denotes a second direction that crosses the first direction, and a symbol z denotes a third direction that crosses each of the first direction and the second direction. The various directions may be perpendicular to each other, without being limited thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Flexible display panels using flexible substrates that are relatively light, strong against impacts and are easily transformed, and flexible display devices including the same, have been developed. A flexible display panel may be relatively weak with respect to external impacts, so a flexible display device includes a cover window for protecting the flexible display panel and through which an image is transmitted from the flexible display panel to be visible from a position outside the flexible display device.

The flexible display devices may be classified into a bendable display device, a foldable display device, a rollable display device, and a stretchable display device according to usage or types. Among them, the foldable display device may be folded or unfolded like a book.

The foldable display device may be folded to be compactly portable when not in use, and may be unfolded to display a relatively wide screen during use. When the foldable display device is repeatedly folded and unfolded, a bent area of the display panel (hereinafter "a bending area") may be deformed and the bending area may be damaged.

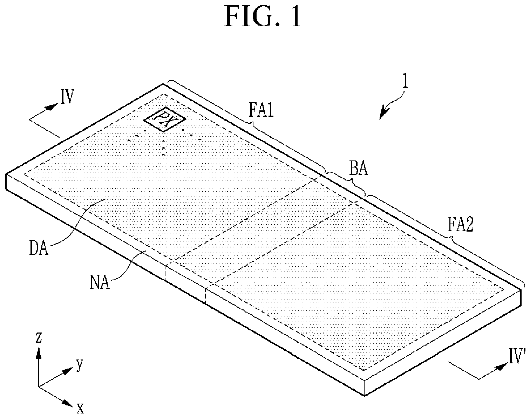

A flexible display device will now be described with reference to FIG. 1 to FIG. 3.

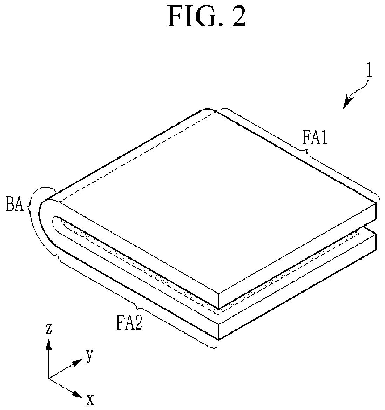

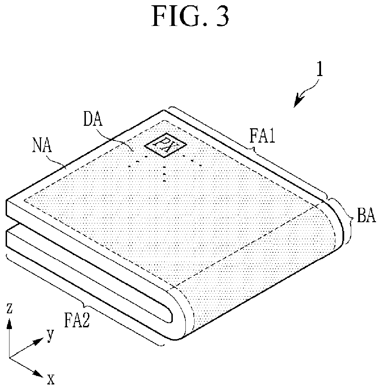

FIG. 1 shows a schematic perspective view of an exemplary embodiment of a flexible display device 1 which is unfolded, FIG. 2 shows a schematic perspective view of an exemplary embodiment of the flexible display device 1 shown in FIG. 1, which is folded, and FIG. 3 shows a schematic perspective view of an exemplary embodiment of the flexible display device 1 shown in FIG. 1, which is folded.

The flexible display device 1 (a display device 1, hereinafter) may be unfolded to be flat as shown in FIG. 1, and may be a display device 1 which is foldable into the shapes shown in FIG. 2 and/or FIG. 3. The display device 1 may include a bending area BA, and a first flat area FA1 and a second flat area FA2 provided on respective sides of the bending area BA. The bending area BA represents a portion of the display device 1 which is bendable and which is bent when the display device 1 is folded. The first flat area FA1 and the second flat area FA2 (e.g., flat areas FA) represent portions of the display device 1 which are not substantially bent even when the display device 1 is folded.

One bending area BA is illustrated, however, the display device 1 may include the bending area BA provided in plurality (e.g., bending areas BA) that are separated from each other and/or are bent with different curvature radii from each other. In an exemplary embodiment, for example, the display device 1 may include at least two bending areas BA and at least three flat areas FA. The display device 1 may be bendable about a bending axis.

The display device 1 may include a display area DA for displaying an image and a non-display area NA which is adjacent to the display area DA. In an exemplary embodiment, the non-display area NA may surround the display area DA in a top plan view. The display area DA may correspond to a screen or a display screen of the display device 1, at which an image is displayed. A pixel PX may be provided in plurality (e.g., pixels PX within the display area DA). The non-display area NA may correspond to a bezel of the display device 1, at which an image is not displayed.

The display device 1 may, as shown in FIG. 2, be folded (in-folded, hereinafter) so that portions of the display screen may face each other, that is, a screen portion at the first flat area FA1 may face a screen portion at the second flat area FA2. The display device 1 may be folded (out-folded, hereinafter) so that the screen may face outwardly to be exposed to outside the display device 1, as shown in FIG. 3. In the in-folding state, a screen portion at the bending area BA may be covered (e.g., not facing outwardly), and in the out-folding state, the screen portion at the bending area BA may be exposed to outside the display device 1 such that an image is visible from outside the display device 1 and a user may view the image. The display device 1 may be foldable in one or both of the in-folding direction and the out-folding direction. When the display device 1 includes a plurality of bending areas BA, one of the bending areas BA may be an in-foldable, and a different one of the bending area BA may be out-foldable.

The display device 1 may further include a housing. The housing may receive various parts or components configuring the display device 1, for example, a display panel, a driving device, a processor, a memory, a printed circuit board ("PCB"), a battery, a communication module, a speaker, and various sensors.

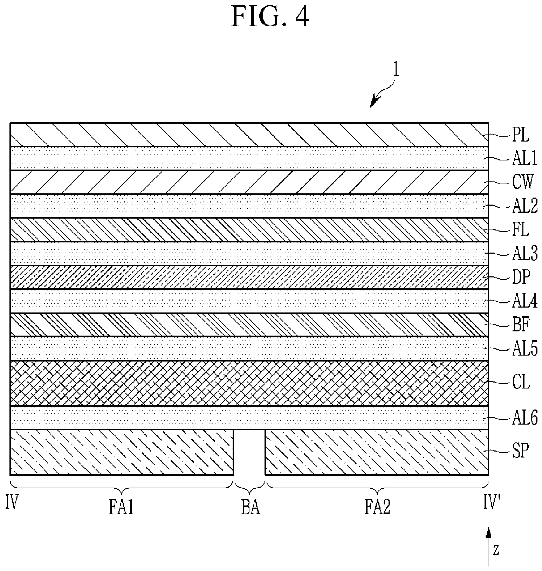

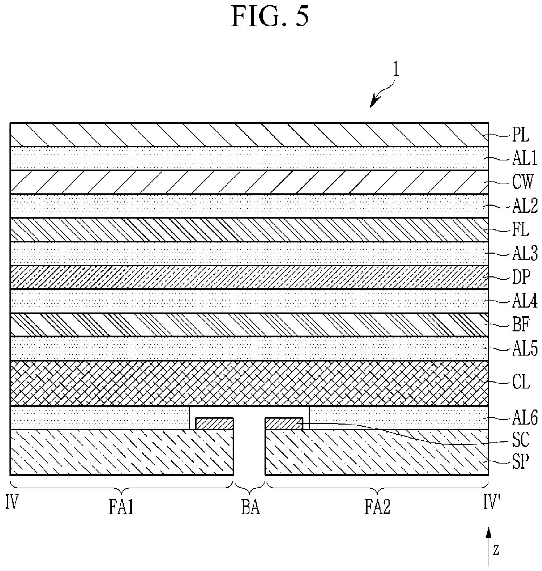

FIG. 4 and FIG. 5 show cross-sectional views of exemplary embodiments of a display device 1, with respect to line IV-IV' in FIG. 1.

Referring to FIG. 4, the display device 1 has a configuration in which various elements are stacked along a thickness direction (e.g., the third direction z). The display device 1 includes a display panel DP, and a cover window CW for protecting the display panel DP. At least one functional layer FL may be provided between the display panel DP and the cover window CW. A base film BF may be provided below the display panel DP. A cushion layer CL may be provided below the base film BF. A support plate SP may be provided below the cushion layer CL. A protection layer PL may be provided above the cover window CW. The display panel DP, the cover window CW, the functional layer FL, the base film BF, the cushion layer CL, the support plate SP, and the protection layer PL may be variously attached to another layer within the display device 1, by adhesive layers AL1 to AL6. One or more of the above stacked elements may include a bending area BA, a first flat area FA1, a second flat area FA2 and a bending axis respectively corresponding to the bending area BA, the first flat area FA1, the second flat area FA2 and the bending axis described above for the display device 1.

The display panel DP represents a panel in which pixels PX for displaying images are provided or formed on a substrate. The display panel DP may include one or more of a light source such as light emitting diodes, corresponding to the pixels PX. The display panel DP is a flexible panel which may be bendable at a portion thereof. In an exemplary embodiment, for example, regarding the display panel DP, a region that corresponds to the bending area BA of the display device 1 may be flexible and bendable, or the display panel DP may be flexible or bendable at other regions or an entirety of regions.

The cover window CW is an optically clear member. In an exemplary embodiment, for example, the cover window CW may have optical characteristics of substantially more than about 90 % of visible light transmission with a wavelength of about 380 nanometers (nm) to about 780 nm, and haze of substantially less than about 1 %. A surface of the cover window CW may be exposed to outside the display device 1, without being limited thereto. The cover window CW may protect the elements that are positioned below the cover window CW, particularly, the display panel DP, from the external environment outside of the cover window CW.

*The cover window CW is a flexible window of which a portion thereof is bendable. In an exemplary embodiment, for example, regarding the cover window CW, a region that corresponds to the bending area BA of the display device 1 may be flexible and bendable. In an exemplary embodiment, an entirety of the cover window CW may be flexible or bendable.*

*The cover window CW may include a polymer film including or made of a polymer such as polyimide ("PI"), polyamide ("PA"), and*/*or polyethylene terephthalate ("PET") for defining a flexible characteristic of the cover window CW. Regarding the cover window CW which is flexible, when the display device 1 is repeatedly folded or is maintained in a folded state, the region of the cover window CW corresponding to the bending area BA may be deformed. As a result, particularly when the display device 1 is unfolded, creases may be generated in the region of the cover window CW which corresponds to the bending area BA, along the second direction y. To prevent or reduce such deformation and creases, the cover window CW may include an inorganic layer on a surface thereof.* A detailed configuration of the cover window CW including an inorganic layer will be described later.

The protection layer PL may be provided to reduce or effectively prevent damage to the cover window CW. The protection layer PL may include a base film and a relatively hard coating layer provided thereon. In an exemplary embodiment, the protection layer PL may be omitted such that the cover window CW defines an outer surface of the display device 1 which is exposed to outside thereof. The base film of the protection layer PL may be a biaxially stretched polymer film.

A functional layer FL may be provided between the display panel DP and the cover window CW. The functional layer FL signifies a layer which performs a specific function within the display device 1, in addition to performing an attaching function for layers adjacent thereto. The functional layer FL may be an antireflection layer and/or a touch panel.

The antireflection layer reduces reflection of external light provided from outside the display device 1. The antireflection layer may include a polarization layer and/or a phase retardation layer, and the polarization layer and/or the phase retardation layer may be a film type. The antireflection layer may be directly provided or formed (e.g., coated) on the display panel DP or the touch panel.

The touch panel may form a touch sensor layer on a polymer film, for example, a polyimide. The touch sensor layer may sense a contact and/or non-contact touch to the display device 1. The touch sensor layer may include touch electrodes including or formed of a transparent conductive material such as an indium tin oxide ("ITO") or an indium zinc oxide ("IZO"), and a metal mesh. The touch electrodes may include or be formed of a single layer or multiple layers. In an exemplary embodiment, the touch sensor layer may not be provided in a touch panel form, and the display panel DP may instead include a touch sensor layer.

The base film BF provided below the display panel DP reduces deformation of the bending area BA, and allows the bending area BA to be bent with a predetermined curvature. The base film BF may reduce buckling and deformation of the elements provided below the display panel DP, and layer decoupling caused by the same. The base film BF may have a relatively high modulus (or a modulus of elasticity), for example, a modulus of about 1 gigapascals (GPa) to about 100 GPa. The base film BF may include or be made of a polymer such as polyimide ("PI") or polyethylene terephthalate ("PET"). The base film BF may be a metal sheet including or made of a metal, or a metal alloy such as Invar or stainless steel (also referred to as SUS).

The cushion layer CL provided below the base film BF may function to protect the elements provided thereon, particularly, the display panel DP. The cushion layer CL may absorb impacts to protect the display panel DP, and allows the display panel DP to be attached to other parts of the display device 1 such as a frame, a bracket, or a housing without damage to the display panel DP. The cushion layer CL may be, for example, a porous layer such as a foam resin. Functional sheets such as a light blocking sheet, a heating sheet and/or a waterproof tape may be further provided below the base film BF in addition to the cushion layer CL.

The support plate SP provided below the cushion layer CL may function to fix the display panel DP in a position. To fold the display device 1, the support plate SP may be disconnected at the bending area BA of the display device 1 to form separated portions of the support plate SP. The separated portions may be connected by a fastening member such as a hinge (not shown). The support plate SP may be a metal plate.

The display device 1 may further include a back cover for covering the support plate SP. The back cover may be exposed to outside of the display device 1 such as to define an outer surface of the display device 1 at a rear side thereof. In an exemplary embodiment, the support plate SP may function as a back cover, without being limited thereto.

Referring to FIG. 4, adhesive layers AL1 to AL6 may be respectively provided between the protection layer PL and the cover window CW, between the cover window CW and the functional layer FL, between the functional layer FL and the display panel DP, between the display panel DP and the base film BF, between the base film BF and the cushion layer CL, and between the cushion layer CL and the support plate SP, to combine the various elements to each other. The adhesive layers AL1 to AL6 may include a pressure sensitive adhesive and/or an optically clear adhesive.

An exemplary embodiment described with reference to FIG. 5 substantially corresponds to the exemplary embodiment described with reference to FIG. 4, except for the adhesive layer AL6 between the cushion layer CL and the support plate SP. In FIG. 5, the adhesive layer AL6 is configured with two portions that are separated from each other to respectively corresponding to the two separated portions of the support plate SP. A gap may be defined between the separated portions of the adhesive layer AL6 and the support plate SP. A step compensation layer SC may be provided at the gap between the separated portions of the adhesive layer AL6, to be provided between the support plate SP and the cushion layer CL.

When the display device 1 in which many elements are stacked is repeatedly folded and unfolded, fatigue stresses are accumulated at the cover window CW, the functional layer FL, and/or the display panel DP and such elements may be deformed (e.g., extended). Particularly, deformation of the cover window CW may cause generation of creases that are visible in the bending area BA of the display device 1.

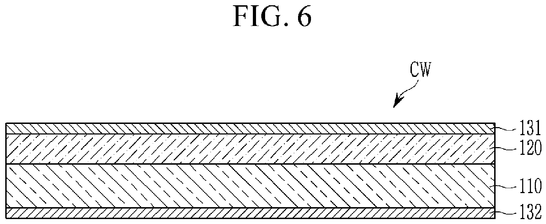

The cover window CW for which deformation thereof from repeated folding and unfolding is reduced, will now be described in detail with reference to FIG. 6. Although not specifically mentioned, FIG. 1 to FIG. 5 will also be referenced so as to describe a relationship of the cover window CW with other elements of the display device 1.

FIG. 6 shows a cross-sectional view of an exemplary embodiment of a cover window.

Referring to FIG. 6, a stacked structure of the cover window CW will now be described. The cover window CW includes a polymer film 110 and a hard coating layer 120 provided thereon. The cover window CW also includes a first inorganic layer 131 provided above the hard coating layer 120 and a second inorganic layer 132 provided below the polymer film 110. Referring to FIG. 6, the first inorganic layer 131 may define a first side (e.g., top side or top outer surface) of the cover window CW, while the second inorganic layer 132 may define a second side (e.g., bottom surface or bottom outer surface) of the cover window CW. The first inorganic layer 131, the hard coating layer 120, the polymer film 110 and the second inorganic layer 132 may variously contact each other, such as to form an interface therebetween, without being limited thereto. Referring to FIG. 6, for example, the polymer film 110 includes a first side and a second side opposing each other along a thickness of the cover window CW, the hard coating layer 120 and the first inorganic layer 131 are in order from the first side of the polymer film 110, and the second inorganic layer 132 contacts the second side of the polymer film 110. In other words: The polymer film 110 is sandwiched between the hard coating layer 120 and the second inorganic layer 132.

Regarding the cover window CW, the first inorganic layer 131 may be provided on a highest side and the second inorganic layer 132 may be provided on a lowest side. The highest side of the cover window CW may be closest to the protection layer PL, and in the absence of the protection layer PL, may define an outer surface of the display device 1. The lowest side of the cover window CW may be furthest from the protection layer PL and/or closest to the display panel DP.

The polymer film 110 represents a basic layer for configuring a cover window CW which is flexible. The polymer film 110 may include a polymer such as a polyimide ("PI"), a polyamide ("PA"), a polyethylene terephthalate ("PET"), a polyethylene naphthalate ("PEN"), a polycarbonate ("PC"), and a polystyrene ("PS"). In an exemplary embodiment, for example, the polymer film 110 may be a colorless polyimide ("CPI") film. The polymer film 110 may include an elastomer such as polyurethane or silicon. The polymer film 110 may be a single layer film or a multiple layer film. The polymer film 110 may have a thickness of several to several hundreds of micrometers (µm). In an exemplary embodiment, for example, the polymer film 110 may have a thickness of equal to or less than about 200 µm, equal to or less than about 100 µm, or equal to or less than about 50 µm.

The polymer film 110 may have flexibility, but may be weak relatively to external environments. Therefore, the hard coating layer 120 is provided or formed on the polymer film 110 so as to protect the polymer film 110 from the external environments, particularly, scratches. The hard coating layer 120 may increase surface rigidity of the cover window CW, and may increase scratch resistance and abrasion resistance.

The hard coating layer 120 includes or is formed of an organic material which may have flexibility or formability. The hard coating layer 120 may be provided or formed by applying an organic material, such as an epoxy resin or acryl-based resin, to the polymer film 110, and hardening (e.g., ultraviolet ("UV") curing) the organic material. The hard coating layer 120 may include an inorganic material. The hard coating layer 120 may have the thickness of equal to or less than about 10 µm, for example, a thickness of about 1 µm to about 10 µm or about 1 µm to about 5 µm. The hard coating layer 120 may have an elongation rate that is equal to or greater than about 3 %. When the thickness of the hard coating layer 120 is greater than 10 µm or the elongation rate is less than 3 %, the hard coating layer 120 may be easily cracked.

The first inorganic layer 131 is provided on the hard coating layer 120, and the second inorganic layer 132 is provided below the polymer film 110. That is, the first inorganic layer 131 and the second inorganic layer 132 (e.g., first and second inorganic layers 131 and 132) are respectively provided or formed on opposing surfaces of the cover window CW. In an exemplary embodiment, the cover window CW may form an outer surface of the display device 1, and within such cover window CW, the first inorganic layer 131 may be exposed to outside of the display device 1, and the second inorganic layer 132 may be attached to the functional layer FL by the adhesive layer AL2.

*The first and second inorganic layers 131 and 132 are glass-like coating layers. The first and second inorganic layers 131 and 132 include inorganic materials such* as a *silicon oxide (SiOₓ), a silicon nitride (SiNₓ), and*/*or a silicon oxynitride (SiON). In an exemplary embodiment, for example, the first and second inorganic layers 131 and 132 may mainly include a silicon oxide, and may secondarily include a silicon nitride. The first and second inorganic layers 131 and 132 may include a metal oxide such* as *an aluminum oxide, a zirconium oxide, and*/*or an indium tin oxide. The first and second inorganic layers 131 and 132 may be provided or formed by a deposition method such* as *a chemical vapor deposition ("CVD").*

*The first inorganic layer 131 may have a thickness of about 100 nm or less. In an exemplary embodiment, for example, the first inorganic layer 131 may have a thickness of about 5 nm to about 30 nm. When the thickness of the first inorganic layer 131 is less than 5 nm, a yield point of the cover window CW may be weak and the hard coating layer 120 may be easily cracked. When the thickness of the first inorganic layer 131 is greater than 30 nm, the first inorganic layer 131 may be easily cracked.*

*The thickness of the second inorganic layer 132 may be about 100 nm or less. For the same reasons related to the first inorganic layer 131, the second inorganic layer 132 may have a thickness of about 5 nm to about 30 nm. In an exemplary embodiment, the first and second inorganic layers 131 and 132 may each have a thickness of about 10 nm to about 15 nm.*

*The cover window CW includes the first and second inorganic layers 131 and 132 at respective opposing sides of the cover window CW, thereby improving a physical characteristic influencing durability of the cover window CW. As a result, generation of deformation such as creases in the bending area BA of the cover window CW may be reduced or prevented.*

Table 1 expresses results of measuring several characteristics of a cover window CW (Comparative Examples 1 and 2) including no first and second inorganic layers 131 and 132, a cover window CW (Comparative Example 3) including the first inorganic layer 131, and an exemplary embodiment of a cover window CW (Exemplary Embodiment 1) including the first and second inorganic layers 131 and 132.

**(Table 1)**

| Characteristics | | Comparative Example 1 | Comparative Example 2 | Comparative Example 3 | Exemplary Embodiment 1 |
|---|---|---|---|---|---|
| Modulus (GPa) | Room temperature (25 °C) | 7.1 | 6.6 | 7.2 | 7.6 |
| | High temperature and high humidity (60 °C/93 %) | 5.2 | 5.7 | 6.3 | 6.7 |
| Yield point (%) | Room temperature | 1.57 | 2.0 | 1.83 | 1.99 |
| | High temperature and high humidity | 1.19 | 1.75 | 1.66 | 2.16 |
| Deformation angle (°) | | 128 | 120 | 110 | 98 |
| Indentation rigidity (Hv) | | 36 | 45 | 47 | 49 |
| Crack strain (%) | | 8 | 7 | 5 | 5 |

Comparative Example 1 shows a cover window CW in which a 10 µm-thickness hard coating layer 120 is provided on a 40 µm-thickness polymer film 110. Comparative Example 2 shows a cover window CW in which a 3 µm-thickness hard coating layer 120 is provided on a 50 µm-thickness polymer film 110. Comparative Example 3 shows a cover window CW in which a 3 µm-thickness hard coating layer 120 and a 5 nm-thickness inorganic layer 131 are provided on a 50 µm-thickness polymer film 110. Exemplary Embodiment 1 shows a cover window CW in which a 3 µm-thickness hard coating layer 120 and a 5 nm-thickness inorganic layer 131 are provided on a 50 µm-thickness polymer film 110 and a 5 nm-thickness second inorganic layer 132 is provided below the polymer film 110. The polymer film 110 is a polyimide film, and the hard coating layer 120 is an epoxy resin.

In Table 1, the deformation angle in degrees (°) represents a folding angle of the cover window CW while the cover window CW is folded with a curvature radius (R) of 1 mm and external forces are removed. A deformation angle which becomes smaller signifies that restoration to an original state (e.g., unfolded state) from a folded state is relatively easier. The indentation rigidity in Vickers Hardness (Hv) is measured by a nanoindentation scheme. The crack strain in percent (%) corresponds to an elongation rate.

Referring to the characteristics of Comparative Examples 1 and 2, it is found that all characteristics are improved to some degree by increasing the thickness of the polymer film 110 and reducing the thickness of the hard coating layer 120. The modulus is shown to be deteriorated at room temperature (degrees Celsius, °C).

According to Comparative Example 3, the cover window CW further includes a first inorganic layer 131 on the top side in comparison to Comparative Example 2. Comparative Example 3 has most characteristics improved, but the yield point is deteriorated at a high temperature and high humidity. According to Comparative Examples 1 to 3, the modulus and the yield point are deteriorated at a high temperature and high humidity compared to room temperature.

In the case of Exemplary Embodiment 1, most of the characteristics are further improved as compared to Comparative Examples 1 to 3. The yield point is dramatically improved for the Exemplary Embodiment 1, particularly in the high temperature and high humidity condition, and is significantly increased compared to the case of room temperature. Therefore, it is found that, as the cover window CW includes the first and second inorganic layers 131 and 132 at respective opposing sides of the cover window CW according to one or more exemplary embodiment, the characteristics relating to deformation resistance such as the yield point, the deformation angle, or the crack strain, are improved. Further, the surface rigidity of the cover window CW according to one or more exemplary embodiment may be improved by improving the indentation rigidity and the modulus. Durability and reliability of the cover window CW according to one or more exemplary embodiment may be increased by improving the characteristics relating to deformation resistance.

Table 2 expresses results of testing by applying several examples of a cover window CW to a display device 1 as shown in FIG. 4 or FIG. 5.

**(Table 2)**

| | Comparative Example 4 | Exemplary Embodiment 2 | Exemplary Embodiment 3 | Exemplary Embodiment 4 |
|---|---|---|---|---|
| Curve deformation amount after high temperature and high humidity (µm) | 130.2 | 67.8 | 53.8 | 46.6 |
| Number of visible lines | 3 | 3 | 1 | 1 |

Comparative Example 4 shows results of applying the cover window CW according to Comparative Example 1 discussed above, to the display device 1 of FIG. 5. Exemplary Embodiment 2 shows results of applying the cover window CW according to Exemplary Embodiment 1 discussed above to the display device 1 of FIG. 5, and Exemplary Embodiment 4 shows results of applying the cover window CW according to Exemplary Embodiment 1 discussed above to the display device 1 of FIG. 4. Exemplary Embodiment 3 shows results of applying the cover window CW generated by changing the thickness of the hard coating layer 120 to 4 µm in the cover window CW according to Exemplary Embodiment 1 discussed above, to the display device 1 of FIG. 4.

Regarding the display device 1 according to Comparative Example 4 and Exemplary Embodiments 2 to 4, the elements PL, FL, DP, BF, CL, SP, and AL1 to AL6 excluding the cover window CW are tested in the same condition. When the cover window CW includes inorganic layers 131 and 132 on the respective opposing sides according to Exemplary Embodiments 2 to 4, a curved deformation amount (e.g., a depth of a deformed portion) after the high temperature and high humidity is reduced to substantially half or less than the same of Comparative Example 4. Therefore, it is found that Exemplary Embodiments 2 to 4 are more efficient in improving the deformation of the bending area BA compared to Comparative Example 4.

Exemplary Embodiment 3, excluding that the hard coating layer 120 is thicker by 1 µm, corresponds to Exemplary Embodiment 4. Exemplary Embodiment 3 shows a higher curved deformation amount than Exemplary Embodiment 4. Due to deformation in the bending area BA, three lines are visible in the bending area BA according to Comparative Example 4 and Exemplary Embodiment 2, but one line is visible according to Exemplary Embodiments 3 and 4.

Table 3 expresses estimation results found by changing the configuration and thicknesses of various layers within the cover window CW.

**(Table 3)**

| | Inorganic layer thickness (nm) | WVTR (g/m².day) | Indentatio n rigidity (Hv) | Pencil hardness (@1 kg) | Sheet resistance (Ω/ m²) | Adhesion under high temp. and high humidity (72 h, 1.5R) |
|---|---|---|---|---|---|---|
| Structure 1 | 5 | 1.4 | 44.9 | 3H | 10¹¹ | 4B |
| Structure 2 | 10 | 1.0 | 49.1 | 3H | 10¹¹ | 4B |
| Structure 3 | 10 | 0.38 | 44.8 | 2H | 10¹¹ | 5B |
| Structure 4 | 30 | 0.47 | 44.4 | 2H | 10¹¹ | 5B (Crack) |
| Structure 5 | 10 | Estimating | 45.2 | 2H | 10¹¹ | Estimating |
| Structure 6 | 10/10 | Estimating | 44.5 | 2H | 10¹¹ | Estimating |

The various layers described below related to Table 3, are provided in order from the polymer film 110, in a direction away from the display panel DP.

In Table 3, Structure 1 shows an estimation result of the cover window CW in which a 3 µm-thickness hard coating layer 120 and a 5 nm-thickness first inorganic layer 131 are provided on the polymer film 110, and Structure 2 shows an estimation result of the cover window CW in which a 3 µm-thickness hard coating layer 120 and a 10 nm-thickness first inorganic layer 131 are provided on the polymer film 110.

Structure 3 shows an estimation result of the cover window CW in which a 1 µm-thickness hard coating layer 120 and a 10 nm-thickness first inorganic layer 131 are provided on the polymer film 110, and Structure 4 shows an estimation result of the cover window CW in which a 1 µm-thickness hard coating layer 120 and a 10 nm-thickness first inorganic layer 131 are provided on the polymer film 110.

Structure 5 shows an estimation result of the cover window CW in which a first 1 µm-thickness hard coating layer 120, a 10 nm-thickness first inorganic layer 131, and a second 1 µm-thickness hard coating layer 120 are provided on the polymer film 110. Structure 6 shows an estimation result of the cover window CW in which a first 1 µm-thickness hard coating layer 120, a first 10 nm-thickness first inorganic layer 131, a second 1 µm-hard coating layer 120, and a second 10 nm-thickness first inorganic layer 131 are provided on the polymer film 110. The polymer film 110 is a 50 µm-thickness polyimide film.

Structures 1 to 6 show that a water vapor transmission rate ("WVTR") in grams per square meter per 24 hours (g/m².day), indentation rigidity, pencil hardness at 1 kilogram (kg), and sheet resistance in ohms per meter squared (Ω/ m2) satisfy a predetermined standard. It is found from the test results that, when the thickness of the first inorganic layer 131 is about 5 nm to about 30 nm, the predetermined standard required by the cover window CW is satisfied. In the adhesion test under high temperature and high humidity performed for 72 hours (72 h), after folding the cover window with the curvature radius (R) of 1.5 mm, a crack is found in the first inorganic layer 131 of Structure 4. To suppress generation of cracks in the first inorganic layer 131, the thickness of the first inorganic layer 131 may be less than about 30 nm.

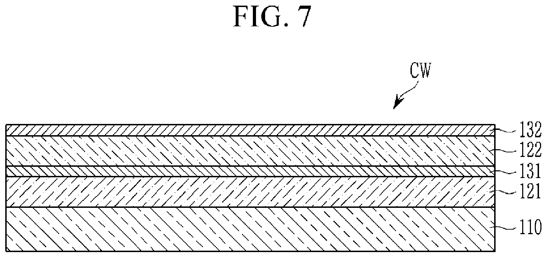

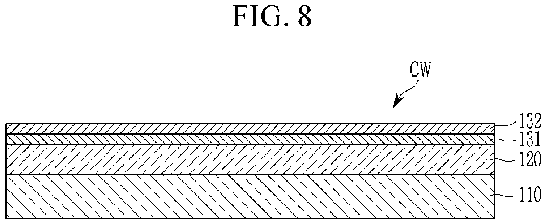

FIG. 7, FIG. 8 and FIG. 9 respectively show a cross-sectional view of a cover window CW. The examples in fig.7 and fig.8 are not falling under the scope of protection. Differences between the respective examples in FIG. 7, FIG. 8 and FIG. 9 and the above-described exemplary embodiment of FIG. 6 will be mainly described.

Referring to FIG. 7, the cover window CW includes a polymer film 110, and a first hard coating layer 121, a first inorganic layer 131, a second hard coating layer 122, and a second inorganic layer 132 that are sequentially stacked on the polymer film 110. The first hard coating layer 121 contacts a top side of the polymer film 110, the first inorganic layer 131 contacts a top side of the first hard coating layer 121, the second hard coating layer 122 contacts a top side of the first inorganic layer 131, and the second inorganic layer 132 contacts a top side of the second hard coating layer 122. The second hard coating layer 122 is disposed facing the first hard coating layer 121 with the first inorganic layer 131 therebetween, and the second inorganic layer 132 is disposed facing the polymer film 110 with each of the first hard coating layer 121, the first inorganic layer 131 and the second hard coating layer 122 therebetween.

In the cover window CW of FIG. 7, the polymer film 110 may be provided on the lowest side, and the second inorganic layer 132 may be provided on the highest side. The first and second hard coating layers 121 and 122 may be organic layers. Accordingly, the cover window CW may have a structure in which an organic layer and an inorganic layer are alternately stacked on the polymer film 110. These layers may be provided in order from the polymer film 110 in a direction away from the display panel DP. The organic layer and the inorganic layer alternately stacked on the polymer film 110 reduces deformation of the cover window CW and increases surface rigidity may thereof. The first and second inorganic layers 131 and 132 may respectively have a thickness of several to several tens of nanometers. A thickness of each of the first and second inorganic layers 131 and 132 may be, for example, equal to or greater than about 5 nm.

Referring to FIG. 8, the cover window CW includes a polymer film 110, and a hard coating layer 120, a first inorganic layer 131, and a second inorganic layer 132 that are sequentially stacked on the polymer film 110. Differing from the exemplary embodiment of FIG. 6, the first and second inorganic layers 131 and 132 are stacked in order from the hard coating layer 120. That is, the hard coating layer 120, the first inorganic layer 131 and the second inorganic layer 132 are in order from the polymer film 110. One relatively thick inorganic layer is provided or formed by a collection of the first and second inorganic layers 131 and 132. The first and second inorganic layers 131 and 132 may be provided or formed by more than one deposition process.

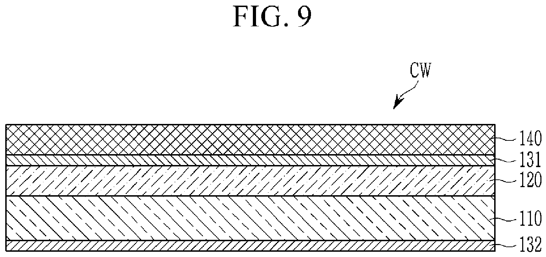

Referring to FIG. 9, the cover window CW includes an anti-fingerprint layer 140 on the first inorganic layer 131 in comparison to the cover window CW of FIG. 6. The cover window CW may be exposed to outside the display device 1 and may be touched by a user's finger. The anti-fingerprint layer 140 may form a top surface of the cover window CW which may be used as a touch side for a touch sensor. The anti-fingerprint layer 140 provides abrasion resistance and/or chemical resistance to the cover window CW. Within the cover window CW, the anti-fingerprint layer 140 is disposed facing the polymer film 110 with the hard coating layer 120 and the first inorganic layer 131 therebetween, the second inorganic layer 132 defines a bottom outer surface of the cover window CW, and the anti-fingerprint layer 140 defines a top outer surface of the cover window CW which is opposite to the bottom outer surface thereof.

Similarly, the cover window CW of FIG. 7 and FIG. 8 may further include an anti-fingerprint layer 140 on the second inorganic layer 132. The anti-fingerprint layer 140 may have a thickness of equal to or less than several hundreds of nanometers. In an exemplary embodiment, for example, the thickness of the anti-fingerprint layer 140 may be equal to or less than about 300 nm.

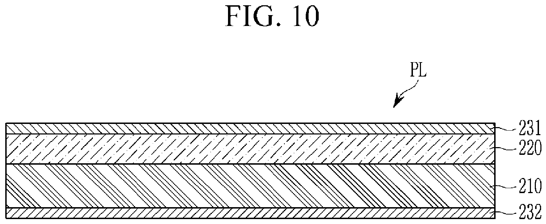

FIG. 10 shows a cross-sectional view of an exemplary embodiment of a protection layer PL.

Referring to FIG. 4, FIG. 5 and FIG. 10, the protection layer PL may be provided on the cover window CW.

The protection layer PL may be attached to the cover window CW so as to protect the cover window CW that may be relatively expensive. The protection layer PL may include a base film 210 and a hard coating layer 220 (e.g., a protection hard coating layer 220) provided thereon. The base film 210 may be a polymer film including or made of a polymer such as polyethylene terephthalate ("PET"), polycarbonate ("PC"), or polymethyl methacrylate ("PMMA").

In a like manner to one or more embodiment of the cover window CW discussed above, the protection layer PL may include a first inorganic layer 231 on the hard coating layer 220, and a second inorganic layer 232 below the base film 210. The first inorganic layer 231 and the second inorganic layer 232 may be positioned relative to the base film 210, in one or more of the configurations of the first inorganic layer 131 and the second inorganic layer 132 positioned relative to the polymer film 110 discussed above. Referring to FIG. 10, along with FIG. 6, FIG. 7, FIG. 8, and FIG. 9, as the protection layer PL includes inorganic layers 231 and 232 at a same side or at respective opposing sides relative to the base film 210, deformation of the bending area BA of the display device 1 may be reduced, and the surface rigidity may be increased.

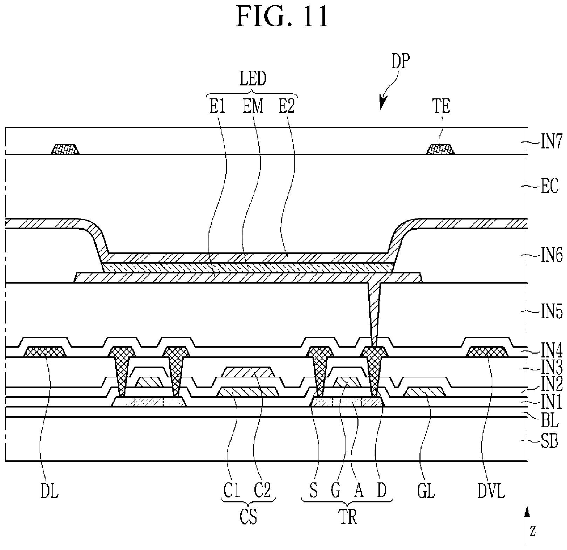

A configuration of the display panel DP included by the display device 1 will now be described with reference to FIG. 11 with the focus on the display area DA.

FIG. 11 shows a cross-sectional view of an example of a display panel DP. FIG. 11 shows an enlarged cross-sectional view of a stacking structure of the display panel DP. The cross-section shown in FIG. 11 may correspond to one pixel PX.

The display panel DP includes a substrate SB, a transistor TR on the substrate SB, and a light source such as a light emitting diode LED connected to the transistor TR.

The substrate SB may be a flexible substrate including or made of a polymer such as polyimide ("PI"), polyamide ("PA"), or polyethylene terephthalate ("PET"). The substrate SB may include a barrier layer for reducing or effectively preventing moisture or oxygen from permeating from outside the display panel DP. In an exemplary embodiment, for example, the substrate SB may include at least one polymer layer and at least one barrier layer, and the polymer layer and the barrier layer may be alternately stacked along a thickness direction of the display panel DP.

A buffer layer BL may be provided on the substrate SB. The buffer layer BL may intercept impurities that may spread to a semiconductor layer A of the transistor TR, from the substrate SB, such as in a process for providing or forming the semiconductor layer A, and may reduce the stress received by the substrate SB. The barrier layer of the substrate SB and the buffer layer BL may each include an inorganic insulating material such as a silicon oxide or a silicon nitride.

The semiconductor layer A of the transistor TR may be provided on the buffer layer BL, and a first insulating layer IN1 may be provided on the semiconductor layer A. The semiconductor layer A may include a source region, a drain region, and a channel region between the source and drain regions. The semiconductor layer A may include a semiconductor material such as polysilicon, an oxide semiconductor, or amorphous silicon. The first insulating layer IN1 may be referred to as a first gate insulating layer, and may include an inorganic insulating material.

A first gate conductor including a gate electrode G of the transistor TR, a gate line GL, and a first electrode C1 of a capacitor CS may be provided on the first insulating layer IN1.

A second insulating layer IN2 may be provided on the first gate conductor. The second insulating layer IN2 may be referred to as a second gate insulating layer, and may include an inorganic insulating material.

A second gate conductor including a second electrode C2 of the capacitor CS may be provided on the second insulating layer IN2. The first gate conductor and/or the second gate conductor may include a metal such as molybdenum (Mo), copper (Cu), aluminum (Al), silver (Ag), chromium (Cr), tantalum (Ta), or titanium (Ti), or a metal alloy thereof.

A third insulating layer IN3 may be provided on the second insulating layer IN2 and the second gate conductor. The third insulating layer IN3 may be referred to as an inter-layer insulating layer, and may include an inorganic insulating material.

A data conductor including a source electrode S and a drain electrode D of the transistor TR, a data line DL, and a driving voltage line DVL may be provided on the third insulating layer IN3. The source electrode S and the drain electrode D may be connected to the source region and the drain region of the semiconductor layer A, respectively, through openings defined in the first, second and third insulating layers IN1, IN2, and IN3. The data conductor may include a metal such as aluminum (Al), copper (Cu), silver (Ag), molybdenum (Mo), chromium (Cr), gold (Au), platinum (Pt), palladium (Pd), tantalum (Ta), tungsten (W), titanium (Ti), or nickel (Ni), or a metal alloy thereof.

A fourth insulating layer IN4 may be provided on the third insulating layer IN3 and the data conductor. The fourth insulating layer IN4 may be referred to as a passivation layer or overcoat layer, and may include an inorganic insulating material.

A fifth insulating layer IN5 may be provided on the fourth insulating layer IN4. The fifth insulating layer IN5 may planarize a profile of the underlying layers and provide a flat surface on which the light emitting diode LED is provided, so as to increase light emission efficiency of the light emitting diode LED. The fourth insulating layer IN4 may be referred to as a planarization layer, and may include an organic insulating material.

A first electrode E1 of the light emitting diode LED may be provided on the fifth insulating layer IN5. The first electrode E1 may be referred to as a pixel electrode. The first electrode E1 may be connected to the drain electrode D through openings in the fourth and fifth insulating layers IN4 and IN5 to receive a data signal for controlling luminance of the light emitting diode LED. The transistor TR connected to the first electrode E1 may be a driving transistor or an emission control transistor electrically connected to the driving transistor.

A sixth insulating layer IN6 may be provided on the fifth insulating layer IN5. The sixth insulating layer IN6 may be referred to as a pixel defining layer, and may include or define an opening overlapping or corresponding to the first electrode E1. An emission member EM including an emission layer may be provided above the first electrode E1 in the opening of the sixth insulating layer IN6, and a second electrode E2 may be provided on the emission member EM. The second electrode E2 may be referred to as a common electrode.

The first electrode E1, the emission member EM, and the second electrode E2 may configure a light emitting diode LED, such as an organic light emitting diode. The first electrode E1 and the second electrode E2 may be an anode and a cathode of the light emitting diode LED, respectively.

An encapsulation layer EC is provided on the second electrode E2. The encapsulation layer EC may reduce or effectively prevent moisture or oxygen from permeating from outside the display panel DP, by encapsulating the light emitting diode LED. The encapsulation layer EC may include at least one inorganic material layer and at least one organic material layer, and the inorganic material layer and the organic material layer may be alternately stacked.

A touch sensor layer including a touch electrode TE may be provided on the encapsulation layer EC. The touch electrode TE may have a mesh form, provided by solid portions crossing each other and defining an opening overlapping or corresponding to the light emitting diode LED. A buffer layer may be provided between the encapsulation layer EC and the touch sensor layer. A seventh insulating layer IN7 for covering the touch electrode TE may be provided on the touch sensor layer.

Referring to FIG. 4 and FIG. 5, the cover window CW and the functional layer FL may be attached to the seventh insulating layer IN7 of the display panel DP by the adhesive layers AL2 and AL3. The base film BF, the cushion layer CL, and the support plate SP may be attached below the substrate SB of the display panel DP by the adhesive layers AL4, AL5, and AL6.

## Claims

1. A cover window (CW) comprising:
a polymer film (110);
a hard coating layer (120) on the polymer film (110);
a first inorganic layer (131) facing the polymer film (110) with the hard coating layer (120) therebetween; and
a second inorganic layer (132) on the polymer film (110) and defining an outer surface of the cover window (CW),
wherein the first inorganic layer (131) and the second inorganic layer (132) include a silicon oxide or a silicon nitride
wherein
the hard coating layer (120) includes an organic material,
the polymer film (110) includes a first side and a second side opposing each other along a thickness of the cover window (CW),
the hard coating layer (120) and the first inorganic layer (131) are in order from the first side of the polymer film (110), and
the second inorganic layer (132) contacts the second side of the polymer film (110),
wherein the first and second inorganic layers (131, 132) are arranged at respective opposing sides of the cover window (CW).

2. The cover window (CW) of claim 1, wherein each of the first inorganic layer (131) and the second inorganic layer (132) has a thickness of 5 nanometers to 30 nanometers.

3. The cover window (CW) of at least one of claims 1 to 2, further comprising an anti-fingerprint layer (140) facing the polymer film (110) with the hard coating layer (120) and the first inorganic layer (131) therebetween,
wherein
the second inorganic layer (132) defines a bottom outer surface of the cover window (CW), and
the anti-fingerprint layer (140) defines a top outer surface of the cover window (CW) which is opposite to the bottom outer surface thereof.

4. The cover window (CW) of at least one of claims 1 to 3, wherein the hard coating layer (120) has a thickness of about 10 micrometers or less.

5. The cover window (CW) of at least one of claims 1 to 4, wherein the polymer film (110) includes a polyimide, polyamide, polyethylene terephthalate, polyethylene naphthalate, polycarbonate or polystyrene.

## Patentansprüche

1. Abdeckfenster (CW), umfassend:
eine Polymerfolie (110);
eine harte Beschichtungsschicht (120) auf der Polymerfolie (110);
eine erste anorganische Schicht (131), die der Polymerfolie (110) zugewandt ist, mit der harten Beschichtungsschicht (120) dazwischen; und
eine zweite anorganische Schicht (132) auf der Polymerfolie (110), die eine Außenfläche des Abdeckfensters (CW) definiert,
wobei die erste anorganische Schicht (131) und die zweite anorganische Schicht (132) ein Siliziumoxid oder ein Siliziumnitrid beinhalten,
wobei
die harte Beschichtungsschicht (120) ein organisches Material beinhaltet,
die Polymerfolie (110) eine erste Seite und eine zweite Seite beinhaltet, die einander entlang einer Dicke des Abdeckfensters (CW) gegenüberliegen,
die harte Beschichtungsschicht (120) und die erste anorganische Schicht (131) von der ersten Seite der Polymerfolie (110) in der richtigen Reihenfolge angeordnet sind und
die zweite anorganische Schicht (132) die zweite Seite der Polymerfolie (110) berührt,
wobei die erste und die zweite anorganische Schicht (131, 132) an jeweiligen gegenüberliegenden Seiten des Abdeckfensters (CW) angeordnet sind.

2. Abdeckfenster (CW) nach Anspruch 1, wobei jede der ersten anorganischen Schicht (131) und der zweiten anorganischen Schicht (132) eine Dicke von 5 Nanometern bis 30 Nanometern aufweist.

3. Abdeckfenster (CW) nach mindestens einem der Ansprüche 1 bis 2, ferner umfassend eine Anti-Fingerabdruck-Schicht (140), die der Polymerfolie (110) zugewandt ist, mit der harten Beschichtungsschicht (120) und der ersten anorganischen Schicht (131) dazwischen,
wobei
die zweite anorganische Schicht (132) eine untere Außenfläche des Abdeckfensters (CW) definiert und
die Anti-Fingerabdruck-Schicht (140) eine obere Außenfläche des Abdeckfensters (CW) definiert, die der unteren Außenfläche davon gegenüberliegt.

4. Abdeckfenster (CW) nach mindestens einem der Ansprüche 1 bis 3, wobei die harte Beschichtungsschicht (120) eine Dicke von etwa 10 Mikrometern oder weniger aufweist.

5. Abdeckfenster (CW) nach mindestens einem der Ansprüche 1 bis 4, wobei die Polymerfolie (110) ein Polyimid, Polyamid, Polyethylenterephthalat, Polyethylennaphthalat, Polycarbonat oder Polystyrol beinhaltet.

## Revendications

1. Fenêtre de couverture (CW) comprenant :
un film polymère (110) ;
une couche de revêtement dur (120) sur le film polymère (110) ;
une première couche inorganique (131) face au film polymère (110) avec la couche de revêtement dur (120) entre eux ; et
une seconde couche inorganique (132) sur le film polymère (110) et définissant une surface externe de la fenêtre de couverture (CW),
dans laquelle la première couche inorganique (131) et la seconde couche inorganique (132) incluent un oxyde de silicium ou un nitrure de silicium
dans laquelle
la couche de revêtement dur (120) inclut un matériau organique,
le film polymère (110) inclut un premier côté et un second côté opposés l'un à l'autre suivant une épaisseur de la fenêtre de couverture (CW),
la couche de revêtement dur (120) et la première couche inorganique (131) sont dans l'ordre à partir du premier côté du film polymère (110), et
la seconde couche inorganique (132) entre en contact avec le second côté du film polymère (110),
dans laquelle les première et seconde couches inorganiques (131, 132) sont agencées au niveau de côtés opposés respectifs de la fenêtre de couverture (CW).

2. Fenêtre de couverture (CW) selon la revendication 1, dans laquelle chacune de la première couche inorganique (131) et de la seconde couche inorganique (132) a une épaisseur de 5 nanomètres à 30 nanomètres.

3. Fenêtre de couverture (CW) selon au moins l'une des revendications 1 et 2, comprenant en outre une couche anti-empreinte (140) face au film polymère (110) avec la couche de revêtement dur (120) et la première couche inorganique (131) entre eux,
dans laquelle
la seconde couche inorganique (132) définit une surface externe basse de la couche de couverture (CW), et
la couche anti-empreinte (140) définit une surface externe haute de la fenêtre de couverture (CW) qui est opposée à la surface externe basse de celle-ci.

4. Fenêtre de couverture (CW) selon au moins l'une des revendications 1 à 3, dans laquelle la couche de revêtement dur (120) a une épaisseur d'environ 10 micromètres ou moins.

5. Fenêtre de couverture (CW) selon au moins l'une des revendications 1 à 4, dans laquelle le film polymère (110) inclut un polyimide, polyamide, poly(téréphtalate d'éthylène), poly(naphtalate d'éthylène), polycarbonate ou polystyrène.
